# EUROPEAN PATENT APPLICATION

(11) **EP 3 176 831 A1**
(43) Date of publication of application: **07.06.2017**
(21) Application number: 15826705.4
(22) Date of filing: 28.07.2015
(51) Int. Cl.: H01L 31/0248, H01L 31/0749

(54) **PHOTOELECTRIC CONVERSION DEVICE, TANDEM PHOTOELECTRIC CONVERSION DEVICE, AND PHOTOELECTRIC CONVERSION DEVICE ARRAY**

(30) Priority: 29.07.2014 JP 2014153534
(71) Applicant: KYOCERA Corporation, Kyoto 612-8501 (JP)
(72) Inventor: ARANAMI, Junji, Kyoto-shi Kyoto 612-8501 (JP)
(74) Representative: Viering, Jentschura & Partner mbB Patent- und Rechtsanwälte
(86) International application number: PCT/JP2015/071326
(87) International publication number: WO 2016/017617

(57) **Abstract**

A photoelectric conversion device includes an electrode layer, a first semiconductor layer located on a main surface of the electrode layer, a plurality of insulating light scattering substances scattered in the first semiconductor layer or scattered at an interface between the first semiconductor layer and the electrode layer, and a second semiconductor layer making a pn junction with the first semiconductor layer on the first semiconductor layer to be located on an opposite side of the electrode layer.

## Description

### Technical Field

The present invention relates to a photoelectric conversion device using a semiconductor thin film as a photoelectric conversion layer and a tandem photoelectric conversion device and a photoelectric conversion device array using the photoelectric conversion device.

### Background Art

Exemplified as a photoelectric conversion device used for a solar photovoltaic power generation, for example, is a thin film photoelectric conversion device using a semiconductor thin film having a thickness of approximately several micrometers as a photoelectric conversion layer. A chalcopyrite-based compound such as CIGS or an amorphous silicon, for example, is adopted as a material of such a semiconductor layer (refer to Japanese Patent Application Laid-Open No. 8-330614, for example). The thin film photoelectric conversion device is appropriate for increasing the area and reducing a cost, so that a research development of a next-generation solar battery using this is advanced.

Such a photoelectric conversion device is formed by planarly arranging a plurality of photoelectric conversion cells in which a lower electrode layer such as a metal electrode, a first semiconductor layer made up of a semiconductor thin film, and a second semiconductor layer different from the first semiconductor layer are stacked in this order on a substrate such as glass plate.

### Summary of the Invention

Improvement of photoelectric conversion efficiency is constantly demanded for the photoelectric conversion device. A method for increasing the photoelectric conversion efficiency of the photoelectric conversion device includes a method that a light path of a light entering the photoelectric conversion device in a photoelectric conversion layer is lengthened to increase a probability of the photoelectric conversion. According to such a method, a spectral sensitivity to a light having a long wavelength is increased, and a thin film can be made thinner by lengthening the light path without reducing the conversion efficiency, and as a result, the conversion efficiency can be increased and the cost reduction can be achieved by increasing a photoelectron density.

In a crystalline photoelectric conversion device using a single-crystal or polycrystal silicon substrate, for example, a texture structure of roughness of approximately several hundreds of nanometers is formed on a surface of the silicon substrate to scatter the light on the surface of the silicon substrate, so that the light path in the silicon substrate is lengthened.

However, when such a texture structure is formed in the thin film photoelectric conversion device using the semiconductor thin film, a portion in which a thickness of the photoelectric conversion layer made up of the semiconductor thin film becomes extremely small occurs, and as a result, the light path is hardly lengthened.

An object of the present invention is to lengthen a light path in a photoelectric conversion layer made up of a semiconductor thin film, so that a photoelectric conversion efficiency of a photoelectric conversion device is increased.

A photoelectric conversion device according to an embodiment of the present invention includes an electrode layer, a first semiconductor layer located on a main surface of the electrode layer, a plurality of insulating light scattering substances scattered in the first semiconductor layer or scattered at an interface between the first semiconductor layer and the electrode layer, and a second semiconductor layer making a pn junction with the first semiconductor layer on the first semiconductor layer to be located on an opposite side of the electrode layer.

A tandem photoelectric conversion device according to another embodiment of the present invention is made up by stacking, when the above photoelectric conversion device is applied as a first photoelectric conversion device and a photoelectric conversion device having a spectral sensitivity different from that of the first photoelectric conversion device is applied as a second photoelectric conversion device, the first photoelectric conversion device and second photoelectric conversion device.

A photoelectric conversion device array according to another embodiment of the present invention is formed by arranging more than one tandem photoelectric conversion device described above, and in each of the adjacent tandem photoelectric conversion devices, the first photoelectric conversion device is electrically connected to another first photoelectric conversion device and the second photoelectric conversion device is electrically connected to another second photoelectric conversion device.

### Brief Description of the Drawings

[Fig. 1] A perspective view illustrating a photoelectric conversion device according to a first embodiment.
[Fig. 2] A cross-sectional view of the photoelectric conversion device illustrated in Fig. 1.
[Fig. 3] A cross-sectional view of a photoelectric conversion device according to a second embodiment.
[Fig. 4] An enlarged cross-sectional view of a main part of a first semiconductor layer in a photoelectric conversion device according to a third embodiment.
[Fig. 5] A cross-sectional view illustrating a tandem photoelectric conversion device and a solar battery array according to the first embodiment.

### Embodiments for Implementing the Invention

Embodiments of the present invention will be described in detail hereinafter with reference to the drawings.

### < A photoelectric conversion device according to a first embodiment>

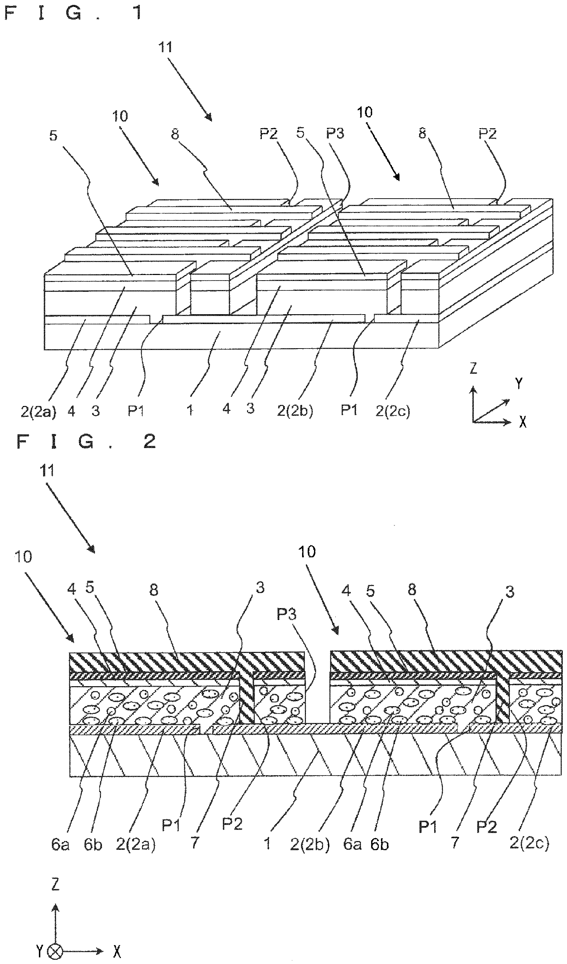

Fig. 1 is a perspective view illustrating a photoelectric conversion device according to an embodiment (the first embodiment) of the present invention, and Fig. 2 is an XZ cross-sectional view of the photoelectric conversion device. Illustrated in Fig. 1 and Fig. 2 is a right-handed XYZ coordinate system in which an arrangement direction of a photoelectric conversion cell 10 (a horizontal direction of the drawing in Fig. 1) is defined as an X axis direction. In a photoelectric conversion device 11 according to the first embodiment, a plurality of photoelectric conversion cells 10 are arranged on a substrate 1 to be electrically connected to each other. Although only two photoelectric conversion cells 10 are shown in Fig. 1 for convenience of the illustration, in the actual photoelectric conversion device 11, a number of photoelectric conversion cells 10 may be planarly (two-dimensionally) arranged in the horizontal direction (the X axis direction) of the drawing and/or further in a direction perpendicular to the horizontal direction (a Y axis direction).

In Fig. 1 and Fig. 2, a plurality of lower electrode layers 2 are planarly arranged on the substrate 1. In Fig. 1 and Fig. 2, the plurality of lower electrode layers 2 include lower electrode layers 2a to 2c arranged in one direction (the X axis direction) with a gap P1 therebetween. A first semiconductor layer 3 is provided to extend from an upper side of the lower electrode layer 2a to an upper side of the lower electrode layer 2b via an upper side of the substrate 1. A second semiconductor layer 4 which has a conductivity type different from the first semiconductor layer 3 is provided on the first semiconductor layer 3. Moreover, on the lower electrode layer 2b, a connected conductor 7 is provided along a side surface of the first semiconductor layer 3 or passes through the first semiconductor layer 3. The connected conductor 7 electrically connects the second semiconductor layer 4 and the lower electrode layer 2b. These lower electrode layer 2, the first semiconductor layer 3, and the second semiconductor layer 4 constitute one photoelectric conversion cell 10, and the adjacent photoelectric conversion cells 10 with a gap P3 therebetween are connected in series with the connected conductor 7 therebetween to obtain a high-power photoelectric conversion device 11. The photoelectric conversion device 11 in the present embodiment is based on an assumption that the light enters from a side of the second semiconductor layer 4, however, the configuration of the photoelectric conversion device 11 is not limited to the above, but also applicable is a configuration that the light enters from a side of the substrate 1.

The substrate 1 supports the photoelectric conversion cell 10. A material used for the substrate 1 includes glass, a ceramic, a resin, and a metal, for example. A blue plate glass (a soda lime glass) having a thickness of approximately 1 to 3 mm, for example, can be used as the substrate 1.

The lower electrode layer 2 (the lower electrode layers 2a, 2b, and 2c) is a layer comprised of a conductor such as Mo, Al, Ti, or Au, for example, provided on the substrate 1. The lower electrode layer 2 is formed to have a thickness of approximately 0.2 to 1 µm using a publicly known thin film forming method such as a sputtering method or an evaporation method.

The first semiconductor layer 3 is a photoelectric conversion layer which absorbs the light to perform a photoelectric conversion. The first semiconductor layer 3 is comprised of a semiconductor thin film. The semiconductor thin film is comprised of a semiconductor and is a thin layer having a thickness of 5µm or less. The thickness of the first semiconductor layer 3 may be 1 to 3 µm from a viewpoint that more positive and negative carrier generated by the photoelectric conversion is extracted to increase the photoelectric conversion efficiency. The first embodiment describes an example that the first semiconductor layer 3 in the photoelectric conversion device 11 is a p-type semiconductor, however, the first semiconductor layer 3 may also be an n-type semiconductor.

A compound semiconductor or a silicon semiconductor, for example, can be used as such a first semiconductor layer 3. Particularly, the first semiconductor layer 3 may be made up mainly of a metal chalcogenide from a viewpoint that the metal chalcogenide has a high optical absorption coefficient and the high photoelectric conversion efficiency can be thereby obtained. The metal chalcogenide is a compound of a metal element and a chalcogen element. The chalcogen element indicates sulfur (S), selenium (Se), and tellurium (Te) in group 16 elements (also referred to as group VI-B elements). The description that the first semiconductor layer 3 is made up mainly of the metal chalcogenide indicates that the first semiconductor layer 3 includes 70 mol% of metal chalcogenide or more.

The above metal chalcogenide includes a chalcopyrite compound such as a group I-III-VI compound or a group II-IV-V compound. In addition, the metal chalcogenide also includes a group I-II-IV-VI compound or a group II-VI compound, for example.

The group I-III-VI compound is a compound of group 11 elements (also referred to as group I-B elements), group 13 elements (also referred to as group III-B elements), and the group 16 elements. Examples of the group I-III-VI compound include CuInSe₂ (copper indium diselenide, also referred to as CIS), Cu(In,Ga)Se₂ (copper indium gallium diselenide, also referred to as CIGS), and Cu(In,Ga)(Se,S)₂ (copper indium gallium diselenide disulfide, also referred to as CIGSS). The first semiconductor layer 3 may have a configuration that a composition is different in a thickness direction such as CIGS having a CIGSS layer as a surface layer. The group I-III-VI compound may be used as the first semiconductor layer 3 from a viewpoint that the higher photoelectric conversion efficiency is obtained.

The group II-IV-V compound is a compound of group 12 elements (also referred to as group II-B elements), group 14 elements (also referred to as group IV-B elements), and group 15 elements (also referred to as group V-B elements). Examples of the group II-IV-V compound include CdSnP₂, CdGeAs₂, CdGeP₂, CdSiAs₂, CdSiP₂, ZnSnSb₂, ZnSnAs₂, ZnSnP₂, ZnGeAs₂, ZnGeP₂, and ZnSiAs₂.

The group I-II-IV-VI compound is a compound semiconductor of the group 11 elements, the group 12 elements, the group 14 elements, and the group 16 elements. Examples of the group I-II-IV-VI compound include Cu₂ZnSnS₄ (also referred to as CZTS), Cu₂ZnSnS₄₋ₓSeₓ (also referred to as CZTSSe; x indicates a number larger 0 but smaller than 4), and Cu₂ZnSnSe₄ (also referred to as CZTSe).

The group II-VI compound is a compound semiconductor of the group 12 elements and the group 16 elements. As the group II-VI compound, CdTe is exemplified, for example.

The first semiconductor layer 3 may be made up mainly of an organic-inorganic composite material from a viewpoint that the semiconductor layer is manufactured at a heating temperature of 100 to 150 °C which is relatively low and thereby can be easily manufactured. The organic-inorganic composite material is a material made by combining an organic constituent and a non-organic constituent on a molecular level and includes CH₃NH₃PbX₃ (X indicates halogen) having a perovskite crystal structure, for example.

In the photoelectric conversion device 11, as shown in Fig. 2, a plurality of insulating light scattering substances 6a and 6b are scattered at an interface between the first semiconductor layer 3 and the lower electrode layer 2 or in the first semiconductor layer 3. In an example shown in Fig. 2, the light scattering substance 6a is scattered in the first semiconductor layer 3 and the light scattering substance 6b is scattered at the interface between the first semiconductor layer 3 and the lower electrode layer 2. The first semiconductor layer 3 needs not to have both the light scattering substance 6a located in the first semiconductor layer 3 and the light scattering substance 6b located at the interface between the first semiconductor layer 3 and the lower electrode layer 2, but may include only the light scattering substance 6a located in the first semiconductor layer 3 or only the light scattering substance 6b located at the interface between the first semiconductor layer 3 and the lower electrode layer 2.

When such light scattering substances 6a and 6b are included, the light entering the first semiconductor layer 3 can be scattered by the light scattering substances 6a and 6b, so that the light path in the first semiconductor layer 3 can be lengthened. Accordingly, a spectral sensitivity to a long-wavelength light can be increased. As a result, a possibility of the photoelectric conversion is increased, and the photoelectric conversion efficiency can be thereby increased.

When a transparent material is used for another member such as the substrate 1 and the lower electrode layer 2 and the light scattering substances 6a and 6b are scattered in the first semiconductor layer 3 to the extent that the optical transparency of the first semiconductor layer 3 is maintained, an optical transparent photoelectric conversion device 11 can be formed. In also the above case, the photoelectric conversion efficiency is increased, compared with a conventional optical transparent photoelectric conversion device which increases the optical transparency by thinning the semiconductor layer, by an effect of the light scattering in the first semiconductor layer 3 and an effect that a generation of a leak source such as a pinhole caused by thinning the first semiconductor layer 3 is decreased by reason that the thickness of the first semiconductor layer 3 is large in appearance.

Furthermore, it is also applicable to change a distribution of the light scattering substances 6a and 6b depending on a portion at a time of planarly and perspectively viewing the first semiconductor layer 3, so that the light scattering substances 6a and 6b have a desired pattern shape, a character, a graphic, and a design, for example. According to the above configuration, the desired pattern can be drawn in the photoelectric conversion device 11 without using a paint, for example. That is to say, it is possible to change a contrasting density or a color tone of the light which is reflected on the photoelectric conversion device 11 or which passes through the photoelectric conversion device 11 in accordance with the distribution of the light scattering substances 6a and 6b. A contained amount of the light scattering substances 6a and 6b may be changed depending on the portion, for example, as a method for changing the distribution of the light scattering substances 6a and 6b depending on the portion. For example, a coating method is applied when the first semiconductor layer 3 is formed, and a plurality of raw material solutions having different contained amount of the light scattering substance 6a are prepared and selectively applied, so that the pattern can be formed. A coating method generally used for a drawing such as a screen printing and a spray coating method, for example, is also effective for more accurate drawing.

Particularly, when the light scattering substance 6a is scattered in the first semiconductor layer 3 and the light scattering substance 6b is also scattered at the interface between the first semiconductor layer 3 and the lower electrode layer 2 as shown in Fig. 2, the photoelectric conversion efficiency is further increased. That is to say, the light entering the first semiconductor layer 3 can be successfully scattered by both the light scattering substances 6a and 6b, and a defect which is easily generated in the interface between the first semiconductor layer 3 and the lower electrode layer 2 can be reduced by the light scattering substances 6b, so that a recombination of the carrier can be suppressed.

The description that the plurality of the insulating light scattering substances 6a and 6b are scattered in at least the first semiconductor layer 3 and a surface of the first semiconductor 3 located on a side of the lower electrode layer 2 indicates a state where the plurality of the light scattering substances 6a and 6b are provided at intervals in an XY section when the first semiconductor layer 3 is cut in parallel with a main surface of the lower electrode layer 2 or in an XY section when the interface between the first semiconductor layer 3 and the lower electrode layer 2 is cut in parallel with the main surface of the lower electrode layer 2. The light scattering substances 6a and 6b may be an aggregate made up of the plurality of the light scattering substances 6a and 6b clumping together, and the aggregates need to be provided at intervals.

An area occupancy rate of the light scattering substances 6a and 6b may be approximately 2 to 30 % in the XY section in the portion which includes the light scattering substances 6a and 6b. Each size of the light scattering substances 6a and 6b may be approximately 50 to 600 nm. That is to say, the light scattering substances 6a and 6b having the size of 50 nm or more can disperse the light more effectively. The light scattering substances 6a and 6b having the size of 600 nm or less can effectively reduce a stress caused by a thermal expansion difference between the light scattering substances 6a and 6b and the first semiconductor layer 3, so that an occurrence of a crack in the first semiconductor layer 3 can be decreased. The size of the light scattering substances 6a and 6b indicates a value obtained by measuring a maximum value of a distance between arbitrary two points in an outer periphery of each of the light scattering substances 6a and 6b at a time of observing the XY section in the portion which includes the light scattering substances 6a and 6b and averaging out the maximum values for the plurality of (10 or more, for example) the light scattering substances 6a and 6b.

With regard to an electrical resistivity of the light scattering substances 6a and 6b, it is sufficient that a volume resistivity is 10¹⁰ Ω cm or more, preferably is 10¹² Ω cm or more from a viewpoint that the recombination of the carrier occurred by the photoelectric conversion is reduced.

An absolute value of a difference between a refraction index of the light scattering substances 6a and 6b and a refraction index of the first semiconductor layer 3 may be 0.8 or more from a viewpoint that the light is effectively scattered by the light scattering substances 6a and 6b.

Examples of a combination having such a refraction index include a combination using CIGS (the refraction index is around 3) or CH₃NH₃Pbl₃ having a perovskite crystal structure (the refraction index is around 2.6) as the first semiconductor layer 3 and using aluminum oxide (the refraction index is approximately 1.7) or silicon oxide (the refraction index is approximately 1.5) as the light scattering substances 6a and 6b.

A material having an optical reflectivity of 60% or more, preferably 80% or more may be used as a material of the light scattering substances 6a and 6b in a region of a light wavelength absorbed by the first semiconductor layer 3. Accordingly, the light used for the photoelectric conversion can be scattered more successfully. A white insulating inorganic particle, for example, may be used as such light scattering substances 6a and 6b. A specific material of the white insulating inorganic particle includes the aluminum oxide or the silicon oxide, for example. When the aluminum oxide or the silicon oxide is applied to the light scattering substances 6a and 6b, a selectivity of wettability with the first semiconductor layer 3 is widened.

Although shapes of the light scattering substances 6a and 6b are not particularly limited, the light scattering substances 6a and 6b having a spherical shape, for example, can be easily contained in the first semiconductor layer 3. Each of the light scattering substances 6a and 6b may have roughness on its surface. According to the above configuration, a light scattering effect of the light scattering substances 6a and 6b can be further increased, so that the light path of the light entering the first semiconductor layer 3 can be lengthened, and the possibility of the photoelectric conversion can be thereby increased. The description that each of the light scattering substances 6a and 6b has the roughness on its surface indicates that when each section of the light scattering substances 6a and 6b is observed, an outer periphery of the section does not have a smooth curved surface but has a plurality of convexes and concaves. A combination made by coupling a plurality of particles (or an aggregate) may be applied as such light scattering substances 6a and 6b having the roughness on their surfaces, and a spalled particle may also be applied.

The light scattering substances 6a and 6b may be made of a porous material having voids each of which has an average pore diameter of approximately 0.1 to 1 nm. According to the above configuration, the light scattering effect can further be increased and an adhesion to the first semiconductor layer 3 can be enhanced. Such a porous material includes zeolite, for example. When the light scattering substances 6a and 6b are made of the porous material, the average pore diameter of the void can be measured by measuring the section of the light scattering substances 6a and 6b by an X-ray small angle scattering method. The light scattering substances 6a and 6b made of such a porous material includes a combination (or an aggregate) in which a plurality of particles are coupled to each other with a space inside between the particles.

The second semiconductor layer 4 is a semiconductor layer having an n-type conductivity type different from that of the first semiconductor layer 3. The first semiconductor layer 3 and the second semiconductor layer 4 are electrically connected to each other to form the photoelectric conversion layer capable of successfully extracting an electrical charge. The second semiconductor layer 4 may be made up of a plurality of layers, and at least one layer in the plurality of layers may be a high resistance layer.

Examples of the second semiconductor layer 4 include CdS, ZnS, ZnO, In₂S₃, In₂Se₃, In (OH, S), (Zn, In) (Se, OH), and (Zn, Mg) O. The second semiconductor layer 4 is formed to have a thickness of 10 to 200 nm by a chemical bath deposition (CBD) method, for example. In(OH, S) indicates a mixed crystal compound in which In is contained as a hydroxide and a sulfide. (Zn, In) (Se, OH) is a mixed crystal compound in which Zn and In are contained as a selenide and a hydroxide. (Zn, Mg) O is a compound in which Zn and Mg are contained as an oxide.

As the example shown in Fig. 1 and Fig. 2, an upper electrode layer 5 may be further provided on the second semiconductor layer 4. The upper electrode layer 5 is a layer having a resistivity lower than that of the second semiconductor layer 4. Since the upper electrode layer 5 is provided, electric charges generated in the first semiconductor layer 3 and the second semiconductor layer 4 can be successfully extracted. From a viewpoint of further increasing the photoelectric conversion efficiency, the resistivity of the upper electrode layer 5 may be lower than 1 Ω·cm and a sheet resistance thereof may be equal to or lower than 50 Ω/□.

The upper electrode layer 5 is a transparent conductive film having a thickness of 0.05 to 3 µm comprised of ITO or ZnO, for example. In order to increase a translucency and conductivity, the upper electrode layer 5 may be formed of a semiconductor having the same conductivity type as that of the second semiconductor layer 4. The upper electrode layer 5 may be formed by a sputtering method, an evaporation method, or a chemical vapor deposition (CVD) method, for example.

Moreover, as shown in Fig. 1 and Fig. 2, a collector electrode 8 may be further formed on the upper electrode layer 5. The collector electrode 8 is an electrode for further successfully extracting the electrical charges generated in the first semiconductor layer 3 and the second semiconductor layer 4. The collector electrode 8 is formed, for example, linearly from one end of the photoelectric conversion cell 10 to the connection conductor 7 as shown in Fig. 1. Accordingly, the electrical charges generated in the first semiconductor layer 3 and the second semiconductor layer 4 are collected in the collector electrode 8 via the upper electrode layer 5, and is successfully passed to the adjacent photoelectric conversion cells 10 via the connection conductor 7.

The collector electrode 8 may have a width of 50 to 400 µm from a viewpoint of increasing a light transmittance to the first semiconductor layer 3 and having a favorable conductivity. Moreover, the collector electrode 8 may include a plurality of branched portions.

The collector electrode 8 is formed by, for example, preparing a metal paste which is obtained by dispersing metal powder such as Ag powder in a resin binder or the like, printing the metal paste into a pattern shape, and curing the metal paste.

In the example shown in Fig. 1 and Fig. 2, the connection conductor 7 is a conductor provided in a groove P2 dividing the first semiconductor layer 3, the second semiconductor layer 4, and the upper electrode layer 5. A metal or a conductive paste, for example, can be used for the connection conductor 7. In the example shown in Fig. 1 and Fig. 2, the connection conductor 7 is formed by extending the collector electrode 8, but not limited thereto. For example, the connection conductor 7 may be formed by extending the upper electrode layer 5.

### <Method for manufacturing the photoelectric conversion device according to the first embodiment>

Next, a method for manufacturing the photoelectric conversion device 11 having the above configuration will be described. Herein, a case where the first semiconductor layer 3 is made of the metal chalcogenide will be described. Firstly, the lower electrode layer 2, which is formed of Mo, for example, is formed into a desired pattern using a sputtering method, for example, on a main surface of the substrate 1 formed of glass, for example.

Subsequently, the first semiconductor layer 3 including the light scattering substances 6a and 6b is formed on the main surface of the lower electrode layer 2. Herein, the first semiconductor layer 3 including the light scattering substance 6b in the interface between the lower electrode layer 2 and the semiconductor layer 3 may be formed as described below.

Firstly, a dispersion solution which is formed by dispersing the light scattering substance 6b in an organic solvent, for example, is applied to the main surface of the lower electrode layer 2, and is subsequently heated to remove the organic solvent. Accordingly, the light scattering substance 6b is deposited on the main surface of the lower electrode layer 2.

Subsequently, the first semiconductor layer 3 is formed on the main surface of the lower electrode layer 2 on which the light scattering substance 6b is deposited. A coating method using a raw material solution which is formed by dispersing or dissolving a metal complex or a metal salt, for example, which is to be a raw material of the first semiconductor layer 3, in an organic solvent can be adopted for forming the first semiconductor layer 3. Specifically, the above raw material solution is applied to the main surface of the lower electrode layer 2 to form a film containing a metal element, and subsequently, the film is heated to a temperature of 450 to 650 °C in an atmosphere including a chalcogen element. Accordingly, the film can be the first semiconductor layer 3 which mainly includes the metal chalcogenide.

When the first semiconductor layer 3 including the light scattering substance 6a in the first semiconductor layer 3 is formed, the first semiconductor layer 3 may be formed using the above raw material solution to which the light scattering substance 6a is further added. Alternatively, it is also applicable to form the first semiconductor layer 3 as a laminated body made up of a plurality of semiconductor layers and provide the light scattering substance 6a in the interface between the semiconductor layers as described below. Specifically, the semiconductor layer is formed using the above raw material solution, and subsequently, the dispersion solution is applied to the semiconductor layer to deposit the light scattering substance 6a on the semiconductor layer. Subsequently, the second semiconductor layer is further formed, using the raw material solution, on the semiconductor layer on which the light scattering substance 6a is deposited.

When the first semiconductor layer 3 is CIGS, for example, a solution made by dissolving a single source complex, in which Cu, In, and Se are contained in one organic complex compound, or a single source complex, in which Cu, Ga, and Se are contained in one organic complex compound, (refer to a specification of US Patent No. 6992202) in a solvent such as pyridine or aniline, for example, can be applied as the above raw material solution.

After the first semiconductor layer 3 is formed, the second semiconductor layer 4 and the upper electrode layer 5 are sequentially formed on a main surface of the first semiconductor layer 3 located on opposite side of the lower electrode layer 2 using a CBD method or a sputtering method, for example. Subsequently, the first semiconductor layer 3, the second semiconductor layer 4, and the upper electrode layer 5 are processed through a mechanical scribing process, for example, to form a groove for the connection conductor 7.

Subsequently, for example, a conductive paste, which is obtained by dispersing a metal powder such as Ag powder in a resin binder or the like, is printed in a pattern shape on the upper electrode layer 5 and in the groove, and the collector electrode 8 and the connection conductor 7 are formed by heating and curing the printed conductive paste.

Finally, the first semiconductor layer 3 to the collector electrode 8 are removed at a position shifted from the connection conductor 7 through a mechanical scribing process so as to provide a plurality of photoelectric conversion cells 10 being divided, thereby obtaining the photoelectric conversion device 11 showing in Fig. 1 and Fig. 2.

According to the present invention, the effect achieved by adding the light scattering substances 6a and 6b according to the above present embodiment can also be obtained by further adding a hole block layer, an electron block layer, a p-type layer, and an n-type layer, for example, in addition to the first semiconductor layer 3.

### <Another example of a method for manufacturing the photoelectric conversion device according to the first embodiment>

Another example of a method for manufacturing the photoelectric conversion device 11 will be described. Described herein is a case where the first semiconductor layer 3 is made of the organic-inorganic composite material such as CH₃NH₃PbX₃ (X indicates halogen) having the perovskite crystal structure, for example. In the above case, a solution made by dissolving the organic-inorganic composite material in an organic solvent such as dimethylformamide (DMF), for example, can be applied as the raw material solution for forming the first semiconductor layer 3. Subsequently, when a film obtained by applying the raw material solution is heated at a temperature of 100 to 150 °C, the semiconductor layer made of the organic-inorganic composite material having the perovskite crystal structure can be manufactured. The other steps are similar to that of the method for manufacturing the above photoelectric conversion device 11, so that the photoelectric conversion device 11 can be manufactured.

It should be noted that the present invention is not limited to the above-described embodiment, and various changes and modifications are possible without departing from the scope of the present invention. The photoelectric conversion device 11 according to the above first embodiment may further include at least one of a hole block layer, an electron block layer, and a hole transport layer in addition to the above configuration. For example, a photoelectric conversion device according to a second embodiment or a third embodiment may also be applied.

### <Photoelectric conversion device according to a second embodiment>

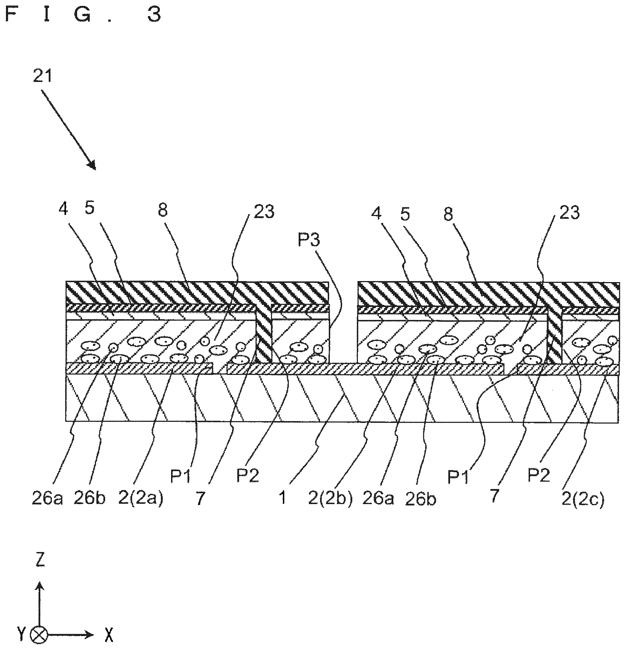

Fig. 3 is a cross-sectional view of the photoelectric conversion device according to another embodiment (the second embodiment) of the present invention. A photoelectric conversion device 21 according to the second embodiment differs from the photoelectric conversion device 11 according to the first embodiment in that a first semiconductor layer 23 includes a light scattering substance 26a inside thereof, and a contained amount of the light scattering substance 26a in the first semiconductor layer 23 is smaller in a portion located on a side closer to the second semiconductor layer 4 in relation to a center of the first semiconductor layer 3 in a thickness direction than a portion located on a side closer to the lower electrode layer 2 in relation to the center of the first semiconductor layer 3 in the thickness direction. In Fig. 3, the components having the same configuration as those shown in Fig. 1 and Fig. 2 are denoted by the same reference signs.

According to the above configuration, a volume of a portion which enables the photoelectric conversion is increased in the portion located on the side closer to the second semiconductor layer 4 in the first semiconductor layer 23 and the light is efficiently scattered in the portion located on the side closer to the lower electrode layer 2 in the first semiconductor layer 23, so that the light path can be lengthened. As a result, the photoelectric conversion efficiency can further be increased.

As shown in Fig. 3, the photoelectric conversion device 21 according to the second embodiment may include a light scattering substance 26b in an interface between the first semiconductor layer 23 and the lower electrode layer 2. According to the above configuration, the photoelectric conversion efficiency is further increased.

### <Photoelectric conversion device of according to a third embodiment>

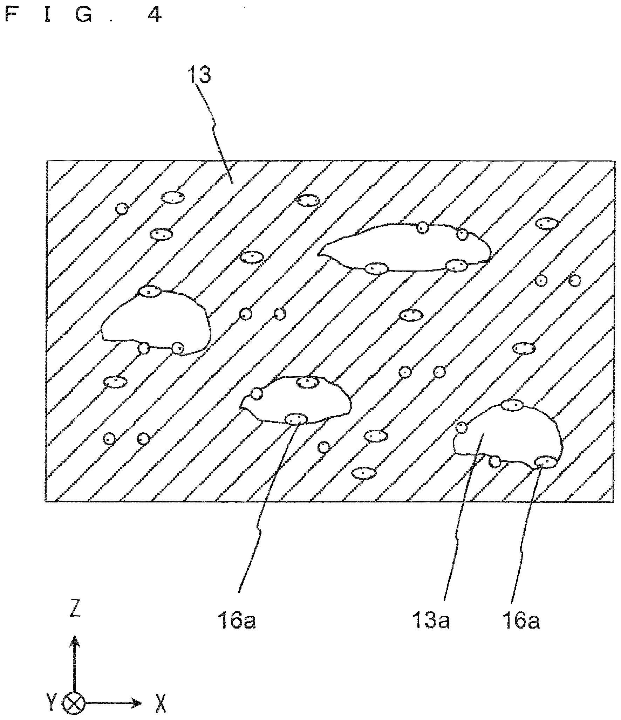

Fig. 4 is an enlarged cross-sectional view of a main part of a first semiconductor layer 13 in a photoelectric conversion device according to another embodiment (the third embodiment) of the present invention. The photoelectric conversion device according to the third embodiment differs from the photoelectric conversion device 11 according to the first embodiment in that the first semiconductor layer 13 has a void 13a inside thereof.

According to the above configuration, the light is easily scattered not only by the light scattering substance 16a but also by the void 13a, so that the light path of the entering light in the first semiconductor layer 13 can be further lengthened, and the possibility of the photoelectric conversion can be further increased. Furthermore, even when a stress is applied on the first semiconductor layer 13 due to a temperature change in use, for example, the void 13a can effectively absorb the stress and thereby effectively reduce a generation of a crack in the first semiconductor layer 13.

The light scattering substance 16a may also be located in an inner surface of the void 13a. In the above case, the light scattering substance 16a successfully fills a defect of the first semiconductor layer 13 in the inner surface of the void 13a, so that even when the first semiconductor layer 13 has the void 13a, the recombination of the carrier in the inner surface of the void 13a can be effectively suppressed.

A size of the void 13a may be approximately 100 to 500 nm from a viewpoint of effectively absorbing the stress on the first semiconductor layer 13. The size of the void 13a indicates an average value obtained by measuring maximum diameters of the plurality of (10 or more, for example) the voids 13a respectively at a time of observing the section of the first semiconductor layer 13 and averaging out the measured maximum diameters. An area occupancy rate of the void 13a in the section of the first semiconductor layer 13 (that is to say, an area occupied by the void 13a in an area of the first semiconductor layer 13 including the void 13a) may be approximately 5 to 50 % from a viewpoint of effectively absorbing the stress on the first semiconductor layer 13.

The size of the void 13a may be larger than the sizes of the light scattering substances 16a and 16b. According to the above configuration, a light scattering angle can be made larger, so that the photoelectric conversion efficiency can be further increased. The size of the void 13a may be 2 to 10 times the size of each of the light scattering substances 16a and 16b from a viewpoint of further increasing the photoelectric conversion efficiency while effectively absorbing the stress on the first semiconductor layer 13.

The above first semiconductor layer 13 can include the void 13a by adjusting a heat condition by heating the first semiconductor layer 13 rapidly when the first semiconductor layer 13 is formed using the raw material solution, in which the raw material and the light scattering substance 16a are dispersed in the organic solvent, in the steps of forming the first semiconductor layer described in the method for manufacturing the photoelectric conversion device according to the above first embodiment, for example.

### <Example of a tandem photoelectric conversion device>

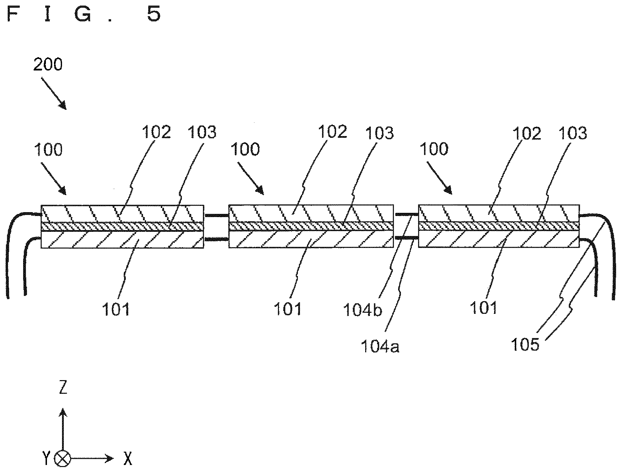

When, as shown by a cross-sectional view in Fig. 5, each photoelectric conversion device of the above embodiments is applied as a first photoelectric conversion device 101 and another photoelectric conversion device having a spectral sensitivity different from that of the first photoelectric conversion device 101 is applied as a second photoelectric conversion device 102, these first photoelectric conversion device 101 and second photoelectric conversion device 102 may be stacked so that those main surfaces face each other to form a tandem photoelectric conversion device 100. The first photoelectric conversion device 101 and the second photoelectric conversion device 102 may have a parallel tandem structure that the first photoelectric conversion device 101 and the second photoelectric conversion device 102 are arranged with an insulating layer 103 or a gap therebetween for taking out electrical power separately or a serial tandem structure that the first photoelectric conversion device 101 and the second photoelectric conversion device 102 are electrically connected to each other. The second photoelectric conversion device 102 may also be applied as each photoelectric conversion device of the above embodiments as long as it has a spectral sensitivity different from that of the first photoelectric conversion device 101.

Herein, the first photoelectric conversion device 101 may be located anterior to the second photoelectric conversion device 102 in an incident direction of the light (a side the light enters first) or may also be located posterior to the second photoelectric conversion device 102 (a side the light enters afterwards). The photoelectric conversion device located anteriorly in the incident direction of the light needs to have a configuration that the light can partially pass through it in accordance with a spectral sensitivity of the photoelectric conversion device which is posteriorly located. Particularly, when the first photoelectric conversion device 101 is located anteriorly in the incident direction of the light, the light scattering substance for scattering the light absorbed by the first photoelectric conversion device 101 is disposed in the first photoelectric conversion device 101, so that the light path of the light is extend and the first photoelectric conversion device 101 can absorb more light, and the photoelectric conversion efficiency can thereby be increased. The similar effect can be obtained by forming metal, for example, on a back surface of the first photoelectric conversion device 101, however, in the tandem photoelectric conversion device 100, the light which is hardly absorbed by the first photoelectric conversion device 101 needs to enter the second photoelectric conversion device 102, so that it is difficult to use the metal which the light does not pass through but is reflected on. Therefore, when the light scattering substance is disposed in the first photoelectric conversion device 101, the photoelectric conversion efficiency can be increased without forming the metal, for example.

A second light scattering substance which scatters the light absorbed by the second photoelectric conversion device 102 may be disposed in a region sandwiched between the first photoelectric conversion device 101 and the second photoelectric conversion device 102 (the insulating layer 103 in Fig. 5). In the above case, even when the second photoelectric conversion device 102 is made of a material such as a single crystal, for example, in which the light scattering substance cannot be disposed, the light path in the second photoelectric conversion device 102 can be extended by the second light scattering substance, so that the light conversion efficiency can be increased. The light scattering substance similar to the above light scattering substance can be used as the second light scattering substance. The second light scattering substance is scattered in the insulating layer 103 which is made of a transparent resin, for example, and is provided between the first photoelectric conversion device 101 and the second photoelectric conversion device 102.

The second photoelectric conversion device 102 may be a photoelectric conversion device using a polycrystal silicon or a single-crystal silicon, for example. These photoelectric conversion devices includes various configurations such as a back contact type or a double-sided power generation type, and the first photoelectric conversion device 101 and the second photoelectric conversion device 102 are electrically connected in parallel with each other, so that an influence of loss due to a current matching is reduced and the conversion efficiency can thereby be increased. In the above case, the insulating layer 103 can be formed between the first photoelectric conversion device 101 and the second photoelectric conversion device 102, so that the above second light scattering substance can be disposed therein. The second photoelectric conversion device 102 may be a photoelectric conversion device using a chalcopyrite-based compound such as CIGS, for example, and in that case, a band gap of the second photoelectric conversion device 102 is made smaller than that of the first photoelectric conversion device 101 so that the second photoelectric conversion device 102 is appropriately used. The back contact type photoelectric conversion device is a photoelectric conversion device having a structure of taking out both positive and negative electrodes to a back surface side of the photoelectric conversion device. The double-sided power generation type photoelectric conversion device is a photoelectric conversion device capable of generating electric power using any of the optical incidences from a front surface and a back surface.

### <Example of a photoelectric conversion device array>

A plurality of tandem photoelectric conversion devices described above may be arranged to form a photoelectric conversion device array 200 shown in Fig. 5. The photoelectric conversion device array 200 has a configuration that in each of the adjacent tandem photoelectric conversion devices 100, the first photoelectric conversion devices 101 are electrically connected to each other via a wiring 104a and the second photoelectric conversion devices 102 are electrically connected to each other via a wiring 104b. According to the above configuration, a power generation amount can be further increased. The photoelectric conversion device array 200 has a configuration that electrical power is taken outside via a wiring 105 from the tandem photoelectric conversion device 100 located at an end part.

### Working Example

The photoelectric conversion device was evaluated as follows. Firstly, a raw material solution for manufacturing a first semiconductor layer made up of CIGS was prepared. The raw material solution was made by dissolving a single source complex, in which Cu, In, and Se were contained in one organic complex compound, and a single source complex, in which Cu, Ga, and Se was contained in one organic complex compound, in pyridine so that a ratio of Cu: In: Ga: Se became 1: 1: 1: 2. Next, the raw material solution was divided into a plurality of samples, and an alumina powder having an average particle diameter of 200 to 500 nm was dispersed as a light scattering substance in each sample with variation of an additive amount as describe below to make dispersion solutions (samples). The additive amount of the alumina powder (Al₂O₃) in each sample was set so that a volume ratio of CIGS and Al₂O₃ met a ratio described below.
Sample 1 ··· CIGS: Al₂O₃ = 1: 0 (Al₂O₃ is not added)
Sample 2 ··· CIGS: Al₂O₃ = 1: 0.1
Sample 3 ... CIGS: Al₂O₃ = 1: 0.33
Sample 4 ... CIGS: Al₂O₃ = 1: 1

Next, each sample was applied to a glass substrate to form a film, and the film was heated at a temperature of 500 °C for one hour and a first semiconductor layer including CIGS was thereby manufactured.

An absorption spectrum of each first semiconductor layer was measured. As a result, each first semiconductor layer indicated an absorption characteristic to a wavelength in a visible light region, and a position of an absorption edge on a long wavelength side became 1020 nm in the sample 1, however, in contrast, the position of the absorption edge became 1060 nm in the sample 2, 1070 nm in the sample 3, and 1100 nm in the sample 4. The above result showed that the light path in the first semiconductor layer was lengthened by adding and dispersing the light scattering substance in the first semiconductor layer, so that the spectral sensitivity to the long-wavelength light could be increased.

### Reference Signs List

- 1:: substrate
- 2, 2a, 2b, 2c:: lower electrode layer
- 3, 13, 23:: first semiconductor layer
- 4:: second semiconductor layer
- 6a, 6b, 16a, 26a, 26b:: light scattering substance
- 10:: photoelectric conversion cell
- 11:: photoelectric conversion device
- 13a:: void

## Claims

1. A photoelectric conversion device, comprising:
an electrode layer;
a first semiconductor layer located on a main surface of the electrode layer;
a plurality of insulating light scattering substances scattered in the first semiconductor layer or scattered at an interface between the first semiconductor layer and the electrode layer;
and a second semiconductor layer making a pn junction with the first semiconductor layer on the first semiconductor layer to be located on an opposite side of the electrode layer.

2. The photoelectric conversion device according to claim 1, wherein
the light scattering substances are scattered in the first semiconductor layer and scattered at the interface between the first semiconductor layer and the electrode layer.

3. The photoelectric conversion device according to claim 1 or 2, wherein
the light scattering substances have roughness on each surface.

4. The photoelectric conversion device according to any one of claims 1 to 3, wherein
each size of the light scattering substances is 50 to 300 nm.

5. The photoelectric conversion device according to any one of claims 1 to 4, wherein
the light scattering substances are made up of a porous material.

6. The photoelectric conversion device according to any one of claims 1 to 5, wherein
the first semiconductor layer includes a void inside the first semiconductor layer.

7. The photoelectric conversion device according to claim 6, wherein a size of the void is larger than each size of the light scattering substances.

8. The photoelectric conversion device according to any one of claims 1 to 7, wherein
the light scattering substances are made up mainly of aluminum oxide or silicon oxide.

9. The photoelectric conversion device according to any one of claims 1 to 8, wherein
the first semiconductor layer is made up mainly of a metal chalcogenide.

10. The photoelectric conversion device according to claim 9, wherein
the metal chalcogenide is a group I-III-VI compound.

11. The photoelectric conversion device according to any one of claims 1 to 8, wherein
the first semiconductor layer is made up mainly of an organic-inorganic composite compound.

12. A tandem photoelectric conversion device, wherein
when the photoelectric conversion device according to any one of claims 1 to 11 is applied as a first photoelectric conversion device and a photoelectric conversion device having a spectral sensitivity different from that of the first photoelectric conversion device is applied as a second photoelectric conversion device, the first photoelectric conversion device and the second photoelectric conversion device are stacked to form the tandem photoelectric conversion device.

13. The tandem photoelectric conversion device according to claim 12, wherein
a second light scattering substance is scattered between the first photoelectric conversion device and the second photoelectric conversion device.

14. The tandem photoelectric conversion device according to claim 12 or 13, wherein
the first photoelectric conversion device and the second photoelectric conversion device are electrically connected in parallel with each other.

15. The tandem photoelectric conversion device according to claim 14, wherein
the second photoelectric conversion device is a back contact type photoelectric conversion device or a double-sided power generation type photoelectric conversion device.

16. A photoelectric conversion device array, wherein
more than one tandem photoelectric conversion device according to claim 12 or 13 are arranged, and in each of the adjacent tandem photoelectric conversion devices, the first photoelectric conversion device is electrically connected to another first photoelectric conversion device and the second photoelectric conversion device is electrically connected to another second photoelectric conversion device.
